# EUROPEAN PATENT SPECIFICATION

(11) **EP 0 902 465 B1**
(45) Date of publication and mention of the grant of the patent: **15.10.2008**
(21) Application number: 97830427.7
(22) Date of filing: 27.08.1997
(51) Int. Cl.: H01L 21/8247, H01L 27/115

(54) **Process for manufacturing electronic virtual-ground memory devices**
Herstellungsverfahren für elektronische Speicherbauelemente mit virtueller Masse
Procédé de fabrication de dispositifs de mémoire électroniques à masse virtuelle

(43) Date of publication of application: 17.03.1999
(73) Proprietor: STMicroelectronics S.r.l., 20041 Agrate Brianza (Milano) (IT)
(72) Inventor: Brambilla, Claudio, 20049 Concorezzo (Milano) (IT); Cassio, Valerio, 12030 Polonghera (Cuneo) (IT); Caprara, Paolo, 20100 Milano (MI) (IT); Cereda, Manlio Sergio, 22050 Lomagna (Lecco) (IT)
(74) Representative: Niederkofler, Oswald

(56) References cited:
- US-A- 4 719 184
- US-A- 4 833 514
- US-A- 5 313 419

## Description

### Field of the Invention

This invention relates to a process for manufacturing electronic memory devices integrated on a semiconductor and formed of matrices of virtual ground cells.

More particularly, the invention relates to a process for manufacturing electronic virtual ground memory devices integrated on a semiconductor and including a matrix of floating gate memory cells, the matrix being formed on a semiconductor substrate with a plurality of continuous bit lines extending across the substrate as discrete parallel stripes, said matrix including a circuit portion for selection transistors, and said devices incorporating decode and address circuit portions having P-channel and N-channel MOS transistors; comprising at least the following steps: forming N-wells in at least one of said substrate portions to accommodate said P-channel transistors; defining the active areas of all the transistors by means of a screening mask, and then growing an isolation layer through the apertures of said mask.

### Background Art

As is known, semiconductor-integrated electronic memory devices of the EPROM or FLASH-EPROM type are constructed in the form of cell matrices divided into sections which are essentially sub-matrices formed of memory cell blocks having predetermined dimensions.

Each block has bias and address lines as required to locate the individual memory cells and decode the information contained therein.

A memory device of this kind is described, for example, in European Patent No. 0 573 728 to this Applicant.

This prior document discloses a process for making an integrated device of the EPROM or FLASH-EPROM type wherein the individual memory blocks comprise a cell matrix made up of a plurality of mutually orthogonal word lines and bit lines. The crosspoints of the plurality of word and bit lines define the memory cells.

A structure of this kind is known in the art as a "tablecloth" or crosspoint matrix, and is peculiar in that the bit lines are formed in the semiconductor substrate by parallel, continuous diffused stripes.

The innovatory aspect of this particular arrangement resides in the presence of few metal contacts in the substrate area which is to accommodate the integrated memory cells; this feature greatly expands the capacity for integration on semiconductor substrates.

The metal contacts are only formed at the opposite ends of the bit lines, and provide termination pads for each of the memory blocks.

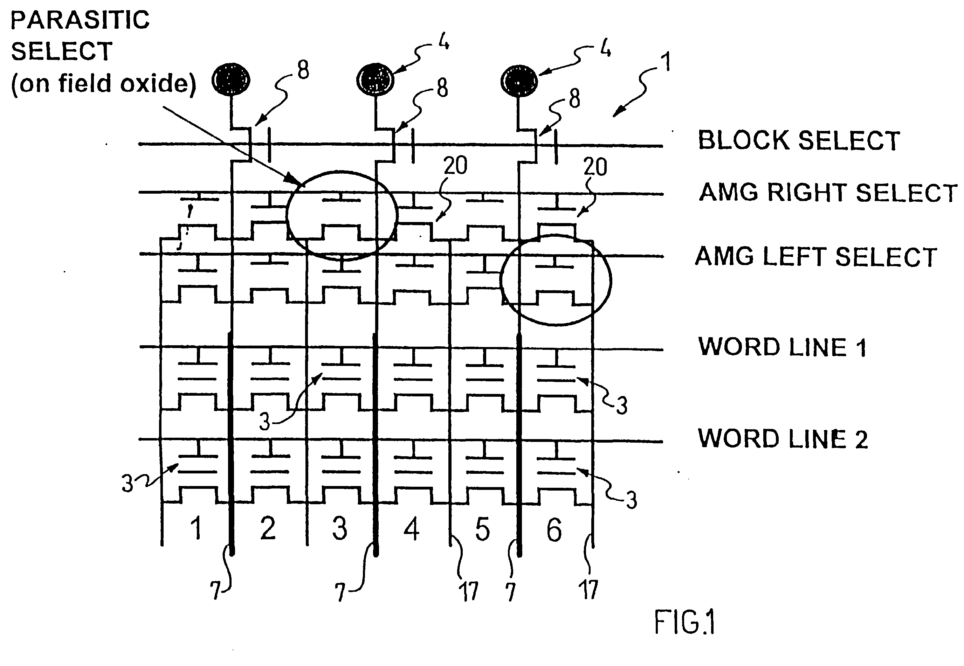

An electric circuit diagram of this configuration is partially shown in the accompaying Figure 1, where the presence of opposite contact regions 4 bordering the plurality of floating gate memory cells 3 can be noticed.

Each memory cell 3 is bounded by a corresponding continuous main bit line 7, and a discontinuous bit line 17 or bit line 'segment'. Each segment is connected to an adjacent continuous bit line by an address active element 20. There is a right or left address active element 20 for each bit line segment.

In addition, FLASH memory cells require field oxide isolation areas in order to maintain a high capacitive ratio between the control gate and the floating gate. The presence of field oxide means, however, that much of the circuit area on the semiconductor substrate will be occupied by it.

Considering the particular instance of EPROMs, which are erased by UV radiation, or of OTP memories, which are not erased at all, a high capacitive ratio between the control gate and the floating gate appears to be overmuch, besides adding to the overall dimensions of the integrated circuit.

Thus, an organization structure of the memory cells is desirable which, while retaining the matrix configuration, would enable the circuit area occupied by the matrix to be greatly reduced.

A prior art solution is disclosed in the US Patent No. 5,313,419 to Chang wherein the features of the preamble of claim 1 are disclosed.

The underlying technical problem of this invention is to provide a novel process for manufacturing electronic memory devices integrated on a semiconductor and comprising virtual ground cell matrices, which process has suitable features to allow very high density memory circuits to be produced with smaller dimensions than conventional devices.

### Summary of the Invention

The solving idea behind this invention is one of eliminating the field oxide isolation areas from the matrix region of the memory cells, and providing isolation for the bit lines in the matrix by having regions doped opposite from the bit lines.

Based on this idea, the technical problem is solved by a method as previously indicated and defined in Claim 1 foll..

The features and advantages of the inventive method will be more clearly apparent from the following description of an embodiment thereof, given by way of non-limitative example with reference to the accompanying drawings.

### Brief Description of the Drawings

In the drawings:
Figure 1 is an electric circuit diagram of a memory block constituting an EPROM or FLASH-EPROM device, according to the prior art;
Figures 2 to 10 are enlarged vertical cross-section views showing a portion of a semiconductor substrate through the evolvement of a manufacturing process according to the invention;
Figure 11 is a perspective view showing schematically a semiconductor portion subjected to a process step in accordance with the invention.

### Detailed Description

Referring to the drawing figures, the process flow of this invention, which leads to forming EPROM and/or OTP memories, will now be described.

For the aspects of the invention to be better understood, reference will be frequently made hereinafter to Figure 1, which is a fragmentary view of an electric circuit diagram for a section or block 1 of an EEPROM memory device of the virtual ground contact-less type.

This memory device may comprise a plurality of sections 1 aggregated to form the memory matrix.

Each section 1 comprises a plurality of cells 3 and plural, right or left, address and decode devices 20. Specifically, the following are provided: floating gate MOS devices forming the individual memory cells 3; control and selection MOS devices 20 performing the functions of addressing and decoding the individual cells 3.

Each n-th memory section 1 is essentially a sub-matrix comprising memory cells 3, organized into rows (word lines) and columns (bit lines), and address devices 20. The sub-matrix is integrated within an area of the semiconductor substrate which is bounded by opposite regions of contacts 4 arranged for contacting the opposite ends of the bit lines formed on the substrate.

For each n-th memory block 1, the contacts 4 which belong to a predetermined region have mirror-like symmetrical correspondance in an opposite contact region at the other end of the bit lines.

Thus, the continuous parallel bit lines 7 which extend within the n-th memory section are bounded by opposite pairs of contact regions 4. Alternatively, these contact regions 4 could be provided at just one end of the bit lines.

The plurality of memory cells 3 are defined by the intersections of the bit lines 7 and the word lines. Specifically, the cells are arranged laterally of such crosspoints and also bound by discontinuous segmented bit lines 17 which are connected to the main bit lines 7 through the right or left decode and address transistors 20.

Advantageously, provided in each substrate area of the section 1, is at least one interruption in each bit line 7 near a region of contacts 4. The interruption may be implemented by inserting a controlled switch to act as a section or block selector.

In a preferred embodiment, each section includes controlled switches 8 connected to the opposite ends of each bit line 7 near the regions of contacts 4. In this way, the bit lines 7 of an n-th memory section 1 can be isolated electrically from the other sections cascade connected thereto.

For convenience of integration of the section selectors, it is preferred to have all the control terminals of the switches 8, inserted near the same region of contacts 4, connected together.

The steps of the manufacturion method which produce the individually selectable memory blocks 1 in integrated form will now be described in detail.

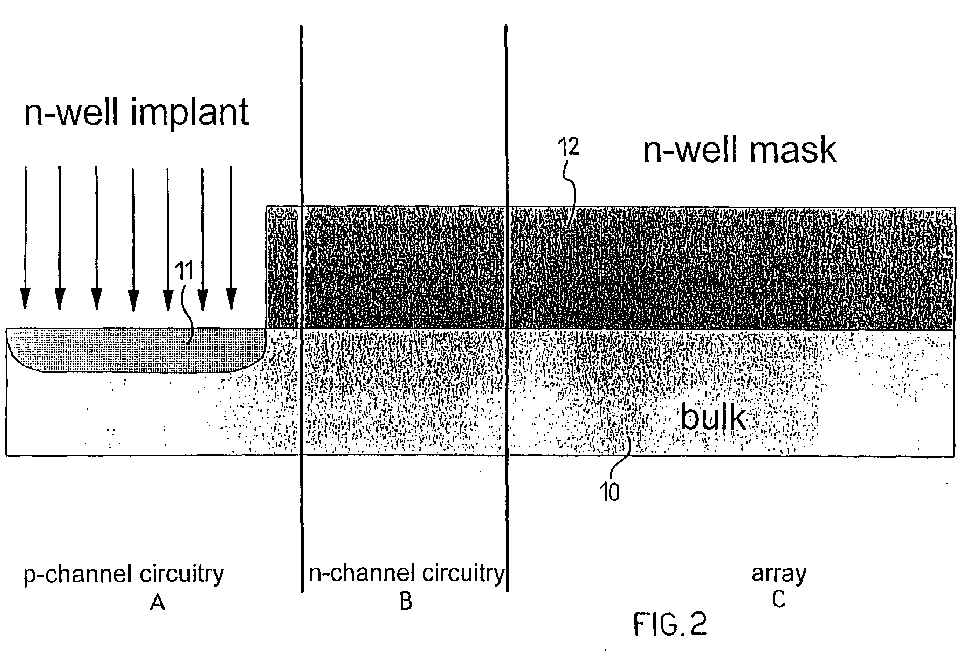

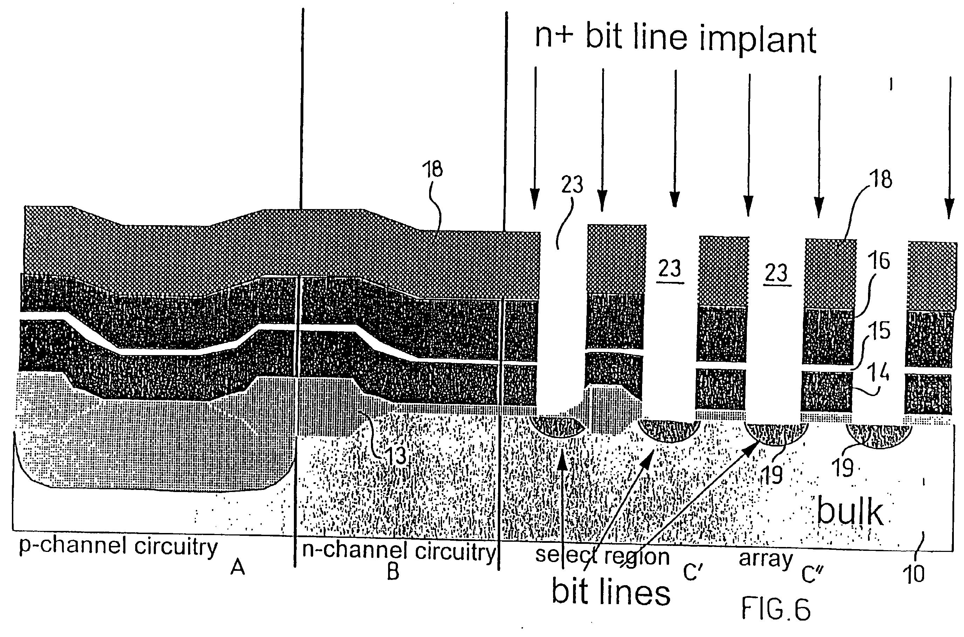

The description of the method proposed herein is based on Figures 2 to 10, which are enlarged views in vertical cross-section of not necessarily adjacent portions of a semiconductor substrate 10 whereon the memory devices of this invention are formed.

More particularly, a first portion, denoted by A, represents the semiconductor zones where the P-channel transistors of the circuitry associated with the memory matrix are formed. A second portion, denoted by B, represents the semiconductor zones where the N-channel transistors of the circuitry associated with the memory matrix are formed.

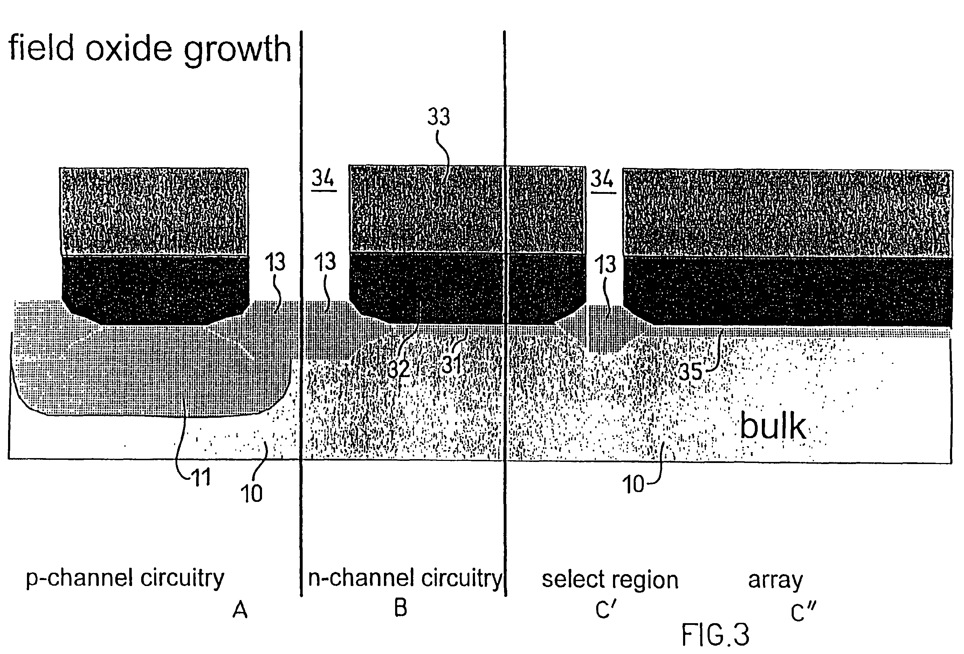

A third portion, denoted by C, represents the semiconductor zones where the cells of the memory matrix are formed. The region C can be divided into two zones C' and C'', shown in Figure 3, which accommodate the selection transistors and the cell matrix proper, respectively.

Throughout the description that follows, some steps of the process will not be discussed in detail, to avoid crowding the specification with elements of secondary importance which may be conventional or known to the skilled person in the art.

Referring to Figure 2, the first step of the process consists of forming N-wells 11 in those portions of the substrate 10 where PMOS transistors of the circuitry associated with the cell matrix are to be formed.

The wells 11 can be formed using an N-well mask 12 to fully cover the substrate 10, excepting the zones thereof where the wells 11 are to be formed.

The mask 12 is then removed conventionally.

The formation of the active areas of all the transistors comes next in the process.

The definition of the active areas, which are isolated from each other by isolation regions consisting of a field oxide 13, is effected conventionally.

For example, a thin oxide layer 31 may be grown to a thickness in the 100Å to 400Å range, a layer 32 of silicon nitride be deposited to a thickness of 800Å to 1500Å, and the field oxide 13 be then grown at a temperature of 900°C to 1080°C in those areas wherefrom the double layer of oxide/silicon nitride has been removed.

The double layer of oxide 31 and nitride 32 is removed using an active area defining mask 33 which is only open at predetermined locations 34 where the field oxide is to be formed.

Adavantageously in this invention, the field oxide 13 is only provided in the circuit portions A and B of the associated circuitry with the matrix, and in the matrix portions C' where the matrix selection transistors locate.

Advantageously, moreover, the gate regions of the matrix cells are formed in a truly planar portion of the semiconductor, for improved planarization of the memory device.

For the purpose, the active area mask 33 is patterned with a narrow window at those zones where isolation must be provided.

In fact, since for a given thermal treatment, a thinner layer of field oxide will grow within a zone of limited surface area, this mask allows a difference of about 2000Å or 3000Å to be obtained between the thicknesses of the field oxide of the selection transistors and the field oxide of the transistors in the circuitry associated with the matrix.

Subsequently to defining the active areas, a layer 31 of gate oxide can be grown to form the N-channel transistors in the portion B and the selection transistors in the portion C'.

A subsequent masking operation allows the gate oxide layer to be removed from the portion C'' of the matrix, and an implantation step to be carried out without masking, for channel doping the memory cells to be formed later and for modifying the threshold voltages of the P-channel and N-channel transistors.

The circuitry may be screened by a mask during the matrix implantation.

A different oxide layer is instead grown in the active matrix areas which will be useful to form the memory cells 3.

A further isolation implanting mask is provided to screen off the N-wells 11. An isolation implantation is then performed at a suitable energy to allocate the dopant beneath the field oxide 13. A ligther implantation can be used instead for the N-channel transistors and the transistors in the zone C'.

In order to produce memory cells with capacitive coupling floating gate MOS devices, the process flow should provide for a multiple deposition onto the entire area of the semiconductor, as required to produce a ply structure comprising a first conductive layer 14 (known as the POLY1), an interpoly dielectric layer 15, and a second conductive layer 16 (the POLY CAP).

The material employed for the conductive layers 14 and 16 is typically polysilicon, and the intermediate dielectric layer may be of ONO (Oxide-Nitride-Oxide), for example.

The POLY CAP layer 16 can be doped at this stage of the process.

A protective oxide layer 18, or top oxide, is deposited over the POLY CAP layer 16.

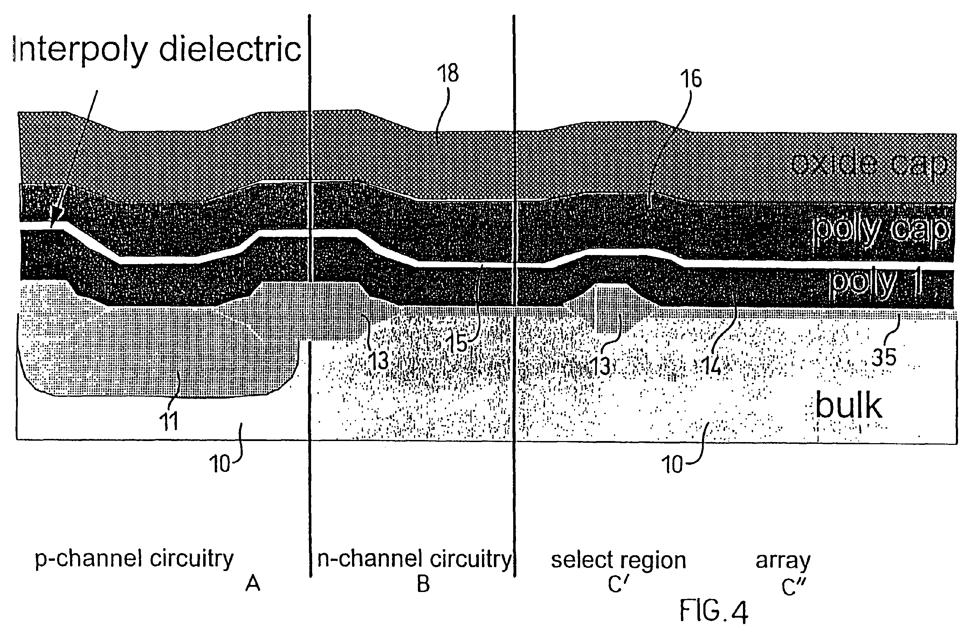

Figure 4 is a sectional view of the ply structure resulting from the last-mentioned sequence of steps.

At this stage of the manufacturion process, the bit lines of the cell matrix are defined.

A mask 21 of resist for defining the polysilicon layer 14, known to the skilled ones as the mask of POLY1, is used to define the bit lines 7.

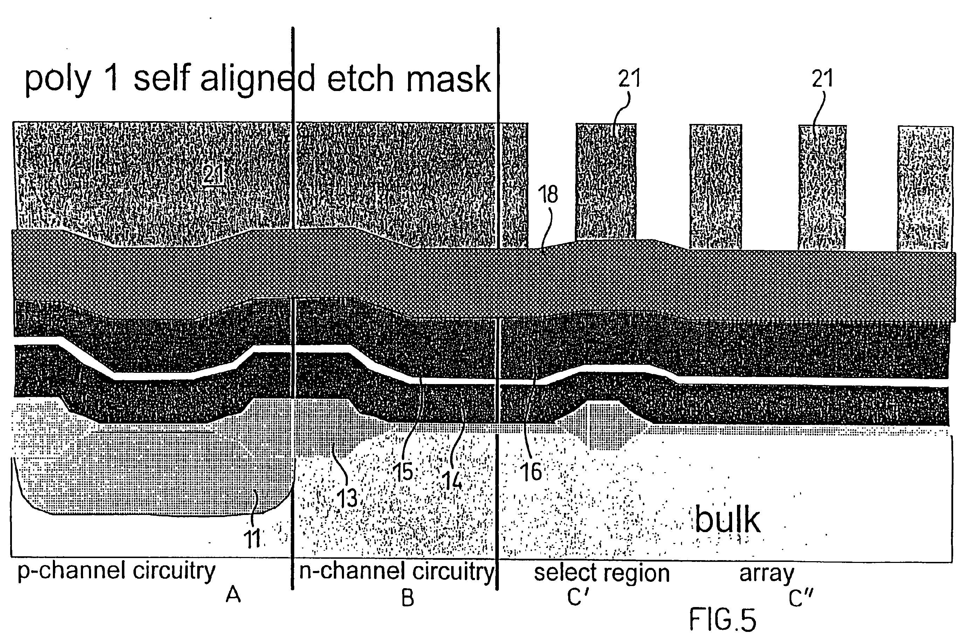

The POLY1 mask is shown in Figure 5.

By a conventional photolithography step, the ply structure unprotected by the POLY1 mask is etched away in cascade to remove, in this order: the second conductive layer 16, intermediate dielectric layer 15, first conductive layer 14, and gate oxide to expose the substrate.

The POLY1 mask is removed, and the gate regions are sealed by an oxidation step.

An ion implantation step using arsenic, needed to confer N⁺ electric conductivity, allows the regions 19 of the bit lines 7 to be defined through the apertures 23 in the ply structure.

The cell matrix will presently appear as formed by a plurality of continuous stripes separated by openings or grooves 23 through which the implantation has been performed for the formation of the bit line regions 19.

The process now provides for the deposition, into the grooves 23 of the matrix, of a first dielectric layer 27, such as a silicon oxide deposited from a liquid or gaseous phase. For example, this layer 27 could be of the TEOS type, if deposited from a liquid phase, or a silane grown from a gaseous phase under predetermined conditions effective to prevent cracking or the formation of micro-voids.

The thickness of the layer 27 is illustratively of 500Å to 3000Å, adequate to isolate the plurality of bit lines 7 from each other and to also cover the gaps therebetween.

Thereafter, a second dielectric layer 28 is deposited to planarize the surface of the semiconductor substrate by filling the gaps between bit lines 7.

This deposition step includes a preliminary dispersion operation or spinning of a gel or liquid phase high-viscosity material, followed by a setting process. The preferred material is Spin-On Glass (SOG), which comprises a mixture of siloxane and alkyl or aromatic organics provided to attenuate the stress on the deposited film. In a preferred embodiment, a mixture of siloxane and methyl compounds is used.

This setting, or more properly densifying and branching process, will be referred to as the "polymerization" hereinafter.

Advantageously, said mixture is converted to a highly planarized dielectric layer 28 by means of appropriate thermal treatments applied at an illustrative temperature of 400°C.

The thickness yielded by this polymerization is illustratively within the range of 3000Å to 6000Å.

At this point, the method of this invention provides for a partial etching of the second dielectric layer 28 using plasma techniques.

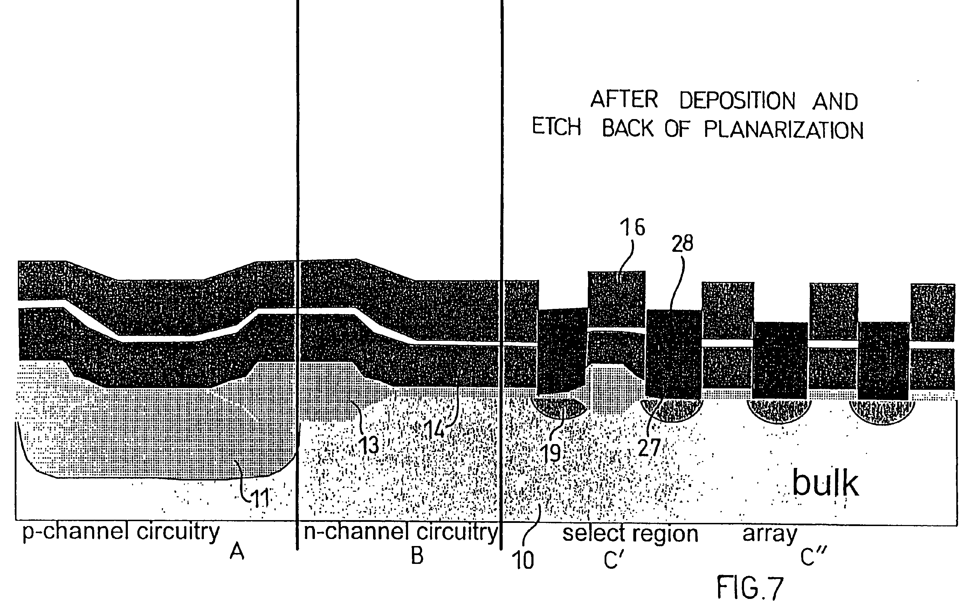

This unmasked back-etching is continued until the surface of the POLY CAP 16 is exposed, with the top oxide being also removed. In this way, the second dielectric layer 28 is confined to just the intersticial regions between the bit lines, as shown in Figure 7.

A prominent feature of this etching is its selectivity to polysilicon. It has also been found experimentally that the selective etching produced by plasma techniques meets more closely the aforesaid requirements.

At this point, an unmasked phosphorus implantation can be performed for doping the POLY CAP 16, if this has not been done previously. In any case, the bit lines will be protected by the planarization dielectric layer 28.

After the planarization process, a new photolithography step will be necessary, using a mask 29 which is commonly referred to as the matrix mask.

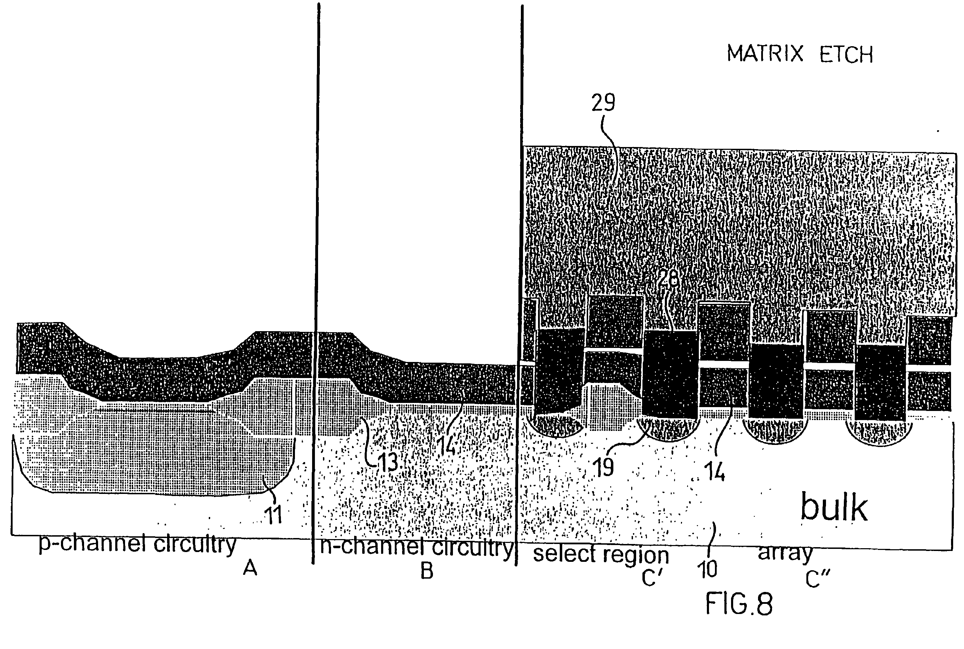

This mask is shown in Figure 8, and will serve to remove the second conductive layer 16 and the intermediate dielectric layer 15 from the portions A and B intended for integrating the P-channel and N-channel transistors.

An optional implantation step could be carried out for adjusting the threshold voltages of the transistors in the portions A and B.

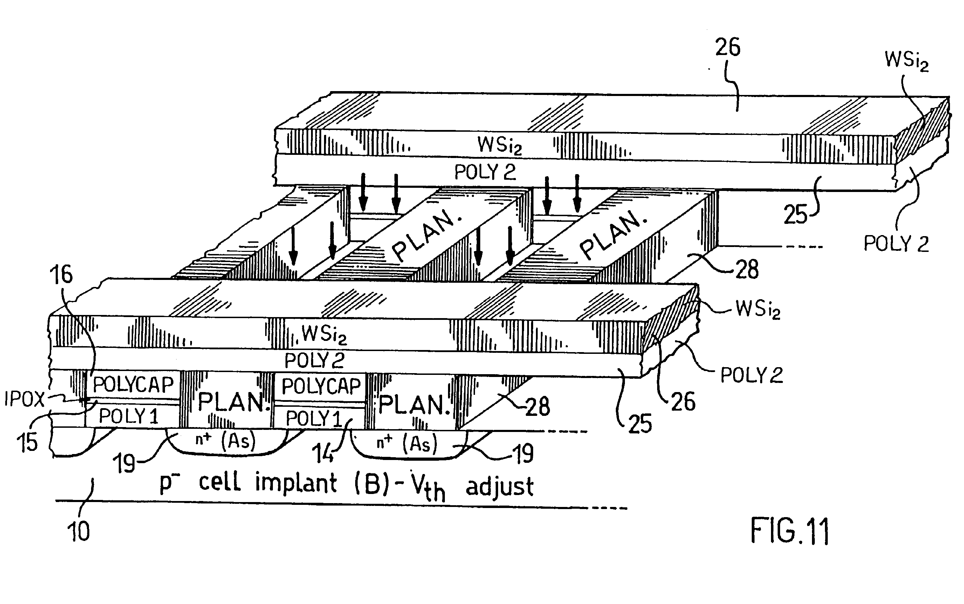

At this point, a multiple deposition can be effected to produce a conductive layer 25, denoted by POLY2, and an optional final conductive layer 26. These layers are more clearly shown in Figure 11, which is a schematic perspective view of the structure provided by the process steps carried out so far.

Materials such as polysilicon and tungsten silicide (WSi₂) are commonly used to form the conductive layer 25 and final conductive layer 26, respectively.

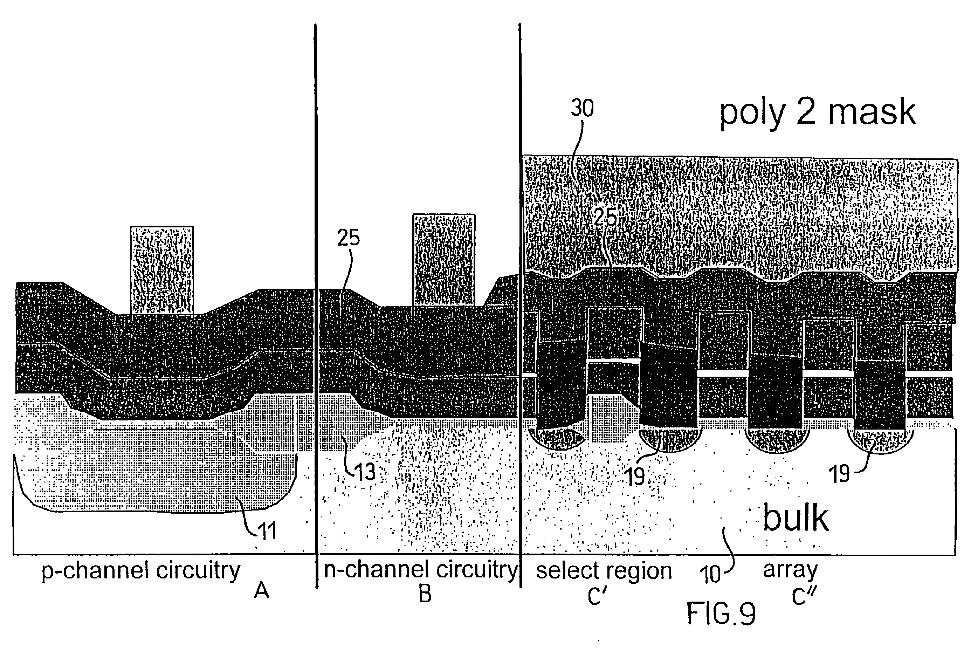

In order to define the plurality of gate regions of the memory cells 3, the N-channel and P-channel transistors of the circuitry, and the selection transistors, an etching should be effected by a photolithography step using a mask 30, referred to as the POLY2 mask and shown in Figure 9.

This mask should have parallel stripes of different widths oriented in an orthogonal direction to that of the bit lines, like the word lines in Figure 1.

Through the POLY2 mask, the gates of all the transistors are defined by etching away the silicide layer 26, POLY2 25, and POLY1 14. The etching is stopped at the gate oxide of the CMOS circuitry, and during this step of matrix etching, the silicide, POLY2, and POLY CAP are etched.

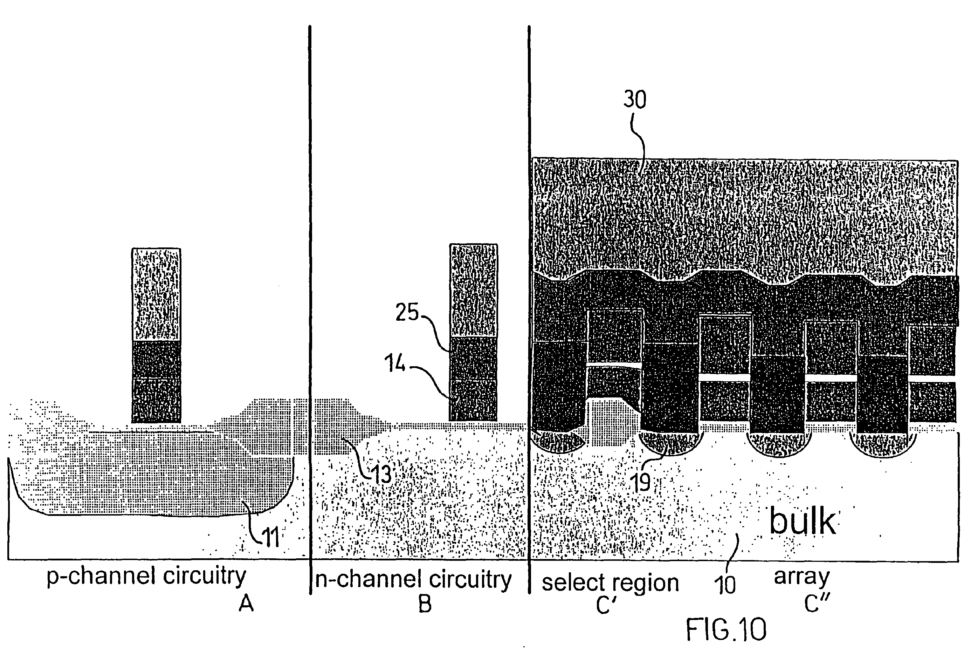

The etching is stopped at the interpoly dielectric, and the resist is not removed, as shown in Figure 10.

A mask is now used for a self-aligned etching operation; with this mask, the circuitry is protected by a double level of resist, so that the matrix etching can be completed to define the word lines. The intermediate dielectric 15, POLY1 14, and gate oxide are etched away.

Before removing the resist, an implantation can be performed to improve the isolation of the bit lines.

As shown in Figure 11, a P⁻ implantation of boron is performed, according to the invention, to improve the isolation of the bit lines 7.

The boron implant affects the substrate regions adjacent to the bit lines 7 doped opposite from the bit lines. In essence, the isolation of the bit lines is ensured by a diode junction which is reverse biased in normal operation of the memory matrix.

To avoid using the double level of resist, the POLY2 and self-aligned etching masks may be arranged to define the circuitry and matrix separately.

This step is completed by a second cell sealing reoxidation.

From now on, the process runs similar to a conventional CMOS process, and the sequence of steps that complete the memory device will be briefly recalled herein below, without relating them to any specific drawings.

Mask N-LDD: this mask is used to implant the source and drain of the P-channel and N-channel transistors, as described in US Patent No. 4,719,184 to this Applicant, for example; the mask is arranged to screen the matrix, for otherwise, the bit lines would be re-implanted and shorted.

Mask P-LDD: this mask is used to re-implant the sources and drains of the P-channel transistors.

Deposition and etching of a dielectric layer to form the spacers.

N⁺ masking for the source and drain implants of the N-channel transistors.

P⁺ masking for the source and drain implants of the P-channel transistors.

Deposition of an isolation dielectric layer.

Contact mask: for defining and etching the contacts.

Contact and ion implantation mask; the removal of the resist will be followed by an RTP thermal treatment to activate the implanted species. this masking level and the thermal treatment are optional because they would only be required for contacts self-aligned to the active area.

Deposition of the barrier, the tungsten, back-etching of same, and metal deposition.

Metal mask: used to define the metal stripes.

Deposition of the finishing dielectric.

Pad exposing mask: used to define and etch pads.

In summary, the manufacturion process proposed herein does solve the technical problem and affords a number of advantages.

A major advantage of the resulting circuit architecture is its compact and simple design. In fact, since no high coupling is required between the floating gate and the control gate, the circuit space for this coupling can be eliminated, while the simple design results from that no dedicated isolation need be provided for the memory matrix.

## Claims

1. A process for manufacturing electronic virtual ground memory devices integrated on a semiconductor and including a matrix (3) of floating gate memory cells, the matrix (3) being formed on a semiconductor substrate (10) with a plurality of continuous bit lines (7) extending across the substrate (10) as discrete parallel stripes, said matrix (3) including a circuit portion (C') for selection transistors (20), and said devices incorporating decode and address circuit portions (A,B) having P-channel and N-channel MOS transistors; comprising at least the following steps:
- forming N-wells (11) in at least one (A) or said circuit portions of said substrate (10) to accommodate said P-channel transistors;
- defining the active areas of all the transistors of said circuit portions (A,B,C') by means of a screening mask (33), and then growing an isolation layer (13) through the apertures (34) of said mask (33);
**characterized in that** said mask (33) is a single mask and is not open over the matrix region (C'') of the memory cells, said memory cells in said matrix region (C'') remaining free of said isolation layer (13).

2. A process according to Claim 1, **characterized in that** said screening mask (33) is patterned to provide said apertures (34) onto said circuit portions (A,B,C') wherein isolation is to be provided, the thickness of said isolation layer (13) over said circuit portion (C') being thinner than a thickness of said isolation layer (13) over the other circuit portions (A,B).

3. A process according to Claim 2, **characterized in that** the difference in thickness of said isolation layer (13) is in the range of 2000Å - 3000Å.

4. A process according to Claim 1, **characterised in that** it comprises a step of implantation in the adjacent areas to the bit line (7) regions (19) using a dopant of the opposite type from that for the bit lines.

5. A process according to Claim 1, **characterized in that** it further comprises the step of:
growing a gate oxide layer (31) on said circuit portions (B,C') and a oxide layer (35) onto said matrix region (C''); depositing, over the whole of the semiconductor, a ply structure consisting of a first conductive layer (14), and intermediate dielectric layer (15), and a second conductive layer (16);
photolithographing, with a POLY1 mask, to define a plurality of parallel apertures (23) in said ply structure to delimit floating gate regions;
self-aligned etching, over the active areas of said ply structure (14,15,16) and over the oxide layer (3), to define said continuous bit lines (7);
implanting to confer a predetermined conductivity on the bit line (7) regions (19);
filling and planarizing, by means of dielectric (27), the apertures (23) over the bit line (7) regions (19);
depositing in combination a conductive layer (25) of POLY2 and a final conductive layer (26);
photolithographing, with a POLY2 mask, to form, in said ply structure, a plurality of parallel apertures defining the word lines and the circuitry;
implanting, through said apertures (23), an opposite type of dopant from the bit lines and in the adjacent substrate regions to the bit lines to improve the isolation of said bit lines (7).

## Patentansprüche

1. Verfahren zum Herstellen von elektronischen Speichervorrichtungen mit virtueller Masse, die in einen Halbleiter integriert sind und eine Matrix (3) von Speicherzellen mit schwebendem Gate aufweisen, wobei die Matrix (3) auf einem Halbleitersubstrat (10) mit einer Mehrzahl von kontinuierlichen Bitleitungen (7) gebildet ist, die sich als einzelne parallele Streifen über das Substrat (10) erstrecken, wobei die Matrix (3) einen Schaltungsbereich (C') für Auswahltransistoren (20) aufweist, und wobei die Vorrichtungen Decodier- und Adressenschaltungsbereiche (A, B) mit P-Kanal- und N-Kanal-MOS-Transistoren aufweisen; wobei das Verfahren zumindest folgende Schritte aufweist:
- Bilden von N-Wannen (11) in mindestens einem (A) von den Schaltungsbereichen des Substrats (10) zum Aufnehmen der P-Kanal-Transistoren;
- Definieren der aktiven Bereiche von allen Transistoren der Schaltungsbereiche (A, B, C') mittels einer Abschirmmaske (33) und anschließendes Aufwachsen-lassen einer Isolierschicht (13) durch die Öffnungen (34) der Maske (33) hindurch;
**dadurch gekennzeichnet, dass** es sich bei der Maske (33) um eine Einzelmaske handelt und diese über dem Matrixbereich (C") der Speicherzellen nicht offen ist, wobei die Speicherzellen in dem Matrixbereich (C") frei von der Isolierschicht (13) bleiben.

2. Verfahren nach Anspruch 1,
**dadurch gekennzeichnet, dass** die Abschirmmaske (33) derart strukturiert ist, dass die Öffnungen (34) auf den Schaltungsbereichen (A, B, C') gebildet werden, in denen eine Isolierung geschaffen werden soll, wobei die Dicke der Isolierschicht (13) über dem Schaltungsbereich (C') dünner ist als eine Dicke der Isolierschicht (13) über den anderen Schaltungsbereichen (A, B).

3. Verfahren nach Anspruch 2,
**dadurch gekennzeichnet, dass** die Differenz in der Dicke der Isolierschicht (13) im Bereich von 2000 Å - 3000 Å liegt.

4. Verfahren nach Anspruch 1,
**dadurch gekennzeichnet, dass** es einen Schritt aufweist, in dem eine Implantierung in den benachbarten Bereichen zu den Bereichen (19) der Bitleitungen (7) unter Verwendung eines Dotierstoffs erfolgt, bei dem es sich um den entgegengesetzten Typ von dem für die Bitleitungen handelt.

5. Verfahren nach Anspruch 1,
**dadurch gekennzeichnet, dass** es ferner folgenden Schritt aufweist:
Aufwachsen-lassen einer Gateoxidschicht (31) auf den Schaltungsbereichen (B, C') und einer Oxidschicht (35) auf dem Matrixbereich (C"); über dem gesamten Halbleiter erfolgendes Aufbringen einer Lagenstruktur, die aus einer ersten leitfähigen Schicht (14), einer zwischengeordneten dielektrischen Schicht (15) und einer zweiten leitfähigen Schicht (16) besteht;
fotolithografische Bearbeitung unter Verwendung einer POLY1-Maske zum Bilden einer Mehrzahl von parallen Öffnungen (23) in der Lagenstruktur, um schwebende Gatebereiche abzugrenzen;
selbstausrichtendes Ätzen über den aktiven Bereichen der Lagenstruktur (14, 15, 16) und über der Oxidschicht (3), um die kontinuierlichen Bitleitungen (7) zu bilden;
Implantieren, um den Bereichen (19) der Bitleitungen (7) eine vorbestimmte Leitfähigkeit zu verleihen;
mittels Dielektrikum (27) erfolgendes Füllen und Einebnen der Öffnungen (23) über den Bereichen (19) der Bitleitungen (7);
kombiniertes Aufbringen einer leitfähigen Schicht (25) aus POLY2 und einer abschließenden leitfähigen Schicht (26);
fotolithografische Bearbeitung unter Verwendung einer POLY2-Maske, um in der Lagenstruktur eine Mehrzahl von parallelen Öffnungen zu bilden, die die Wortleitungen und die Schaltungseinrichtungen definieren;
durch die Öffnungen (23) hindurch erfolgendes Implantieren eines Dotierstoffs vom entgegengesetzten Typ zu dem der Bitleitungen sowie in den den Bitleitungen benachbarten Substratbereichen, um die Isolierung der Bitleitungen (7) zu verbessern.

## Revendications

1. Procédé de fabrication de dispositifs à mémoire électroniques à masse virtuelle intégrés à un semi-conducteur et comprenant une matrice (3) de cellules de mémoire à grille flottante, la matrice (3) étant formée sur un substrat semi-conducteur (10) avec une pluralité de lignes de bits continues (7) s'étendant en travers du substrat (10) sous la forme de bandes parallèles discrètes, ladite matrice (3) comprenant une partie de circuit (C') pour des transistors de sélection (20), et lesdits dispositifs incorporant des parties de circuit de décodage et d'adressage (A, B) ayant des transistors MOS à canal P et à canal N ; comprenant au moins les étapes suivantes :
- la formation de puits N (11) dans au moins une (A) desdites parties de circuit dudit substrat (10) pour recevoir lesdits transistors à canal P ; et
- la définition des zones actives de tous les transistors des parties de circuit (A, B, C') à l'aide d'un masque d'écrantage (33), et ensuite la croissance d'une couche isolante (13) à travers les ouvertures (34) dudit masque (33) ;
**caractérisé en ce que** ledit masque (33) est un simple masque qui n'est pas ouvert sur la région de matrice (C") des cellules de mémoire, lesdites cellules de mémoire de ladite région de matrice (C") restant exemptes de ladite couche isolante (13).

2. Procédé selon la revendication 1, **caractérisé en ce que** ledit masque d'écran (33) est configuré pour ménager lesdites ouvertures (34) en regard desdites parties de circuit (A, B, C') dans lesquelles on doit assurer un isolement, l'épaisseur de ladite couche isolante (13) sur ladite partie de circuit (C') étant plus mince que l'épaisseur de ladite couche isolante (13) sur les autres parties de circuit (A, B).

3. Procédé selon la revendication 2, **caractérisé en ce que** la différence d'épaisseur de ladite couche isolante (13) se situe dans la plage de 2000 Å - à 3000 Å.

4. Procédé selon la revendication 1, **caractérisé en ce qu'**il comprend une étape d'implantation dans les zones adjacentes auxdites régions (19) de lignes de bit (7) en utilisant un dopant du type opposé à celui prévu pour les lignes de bits.

5. Procédé selon la revendication 1, **caractérisé en ce qu'**il comporte en outre les étapes suivantes :
- la croissance d'une couche d'oxyde de grille (31) sur lesdites parties de circuit (B, C') et une couche d'oxyde (35) sur ladite région de matrice (C") ; le dépôt, sur l'ensemble du semi-conducteur, d'une structure stratifiée constituée d'une première couche conductrice (14), d'une couche diélectrique intermédiaire (15) et d'une seconde couche conductrice (16) ;
- la photolithographie, avec un masque POLY1, pour définir une pluralité d'ouvertures parallèles (23) dans ladite structure stratifiée pour délimiter les régions de grille flottante ;
- la gravure auto-alignée, sur les zones actives de ladite structure stratifiée (14, 15, 16) et sur la couche d'oxyde (3), pour définir lesdites lignes de bits continues (7) ;
- l'implantation pour conférer une conductivité prédéterminée sur les régions (19) de lignes de bits (7) ;
- le remplissage et la planarisation, à l'aide d'un agent diélectrique (27), des ouvertures (23) sur les régions (19) des lignes de bits (7) ;
- le dépôt en combinaison d'une couche conductrice (25) de POLY2 et d'une couche conductrice finale (26) ;
- la photolithographie, avec un masque POLY2, pour former, dans ladite structure stratifiée, une pluralité d'ouvertures parallèles définissant les lignes de mots et le circuit ;
- l'implantation, à travers lesdites ouvertures (23), d'un type de dopant opposé à celui des lignes de bits, dans les régions de substrat adjacentes aux lignes de bits pour améliorer l'isolement desdites lignes de bits (7).
